# EUROPEAN PATENT APPLICATION

(11) **EP 4 786 995 A1**
(43) Date of publication of application: **05.08.2026**
(21) Application number: 26150190.2
(22) Date of filing: 05.01.2026
(51) Int. Cl.: G01R 31/389, G01R 31/396, G01R 31/392

(54) **DEVICE AND METHOD FOR BATTERY DIAGNOSIS**

(30) Priority: 06.01.2025 KR 20250001414
(71) Applicant: SAMSUNG SDI CO., LTD., Yongin-si, Gyeonggi-do 17084 (KR)
(72) Inventor: HAN, Jinho, 17084 Yongin-si, Gyeonggi-do (KR); YANG, Jongwoon, 17084 Yongin-si, Gyeonggi-do (KR)
(74) Representative: Gulde & Partner

(57) **Abstract**

A battery diagnosis device includes a temperature detector configured to detect temperatures of battery cells. An impedance detection device is configured to generate an AC current signal flowing through the battery cells, detect an AC voltage signal corresponding to the AC current signal for each of the battery cells, and detect impedance data of each of the battery cells based on the AC current signal and the AC voltage signal. A controller is configured to activate or deactivate the impedance detection device according to a temperature deviation of the battery cells and detect an abnormal cell among the battery cells based on the impedance data when the impedance detection device is activated.

## Description

### BACKGROUND OF THE DISCLOSURE

### (a) Field

The present disclosure relates to a device and a method for battery diagnosis.

### (b) Description of the Related Art

Unlike a primary battery that is cannot be recharged, a secondary battery is capable of being repeatedly charged and discharged. A low-capacity secondary battery is used in portable small electronic devices such as smartphones, feature phones, laptop computers, digital cameras or camcorders. Large-capacity secondary batteries are widely used as power sources for driving motors of hybrid vehicles, electric vehicles, or the like and as electric power storage devices. A secondary battery includes an electrode assembly including a positive electrode and a negative electrode, a case accommodating the electrode assembly, and an electrode terminal connected to the electrode assembly, and the like.

In general, the electrode assembly includes a positive electrode, a negative electrode, and a separator interposed between the positive electrode and the negative electrode, a case accommodating the electrode assembly, and an electrode terminal electrically connected to the electrode assembly. An electrolyte solution is injected into the case to enable charging and discharging of the battery through an electrochemical reaction between the positive electrode, the negative electrode, and the electrolyte solution. A shape of the case may vary depending on the use of the battery, and may be, for example, cylindrical or rectangular.

A diagnostic method based on an electrochemical impedance spectroscopy (EIS) measures an impedance of the battery by applying an AC (alternating current) signal of various frequency bands to the battery and then analyzing current and voltage responses of the battery.

The information disclosed in this section is only for improving understanding of the background of the present disclosure. It may include information that does not constitute prior art.

### SUMMARY OF THE DISCLOSURE

The present disclosure provides a battery diagnosis device and method of minimizing electric power consumption due to electrochemical impedance spectroscopy (EIS) diagnosis of a battery system.

However, technical problems solved by the present disclosure are not limited to the above-described problems, and other technical problems not mentioned will be clearly understood by those skilled in the art from a description of the present disclosure below.

A battery diagnosis device according to embodiments of the present disclosure includes: a temperature detector configured to detect temperatures of battery cells; an impedance detection device configured to generate an AC (alternating current) current signal flowing through the battery cells, detect an AC voltage signal corresponding to the AC current signal for each of the battery cells, and detect impedance data of each of the battery cells based on the AC current signal and the AC voltage signal; and a controller configured to activate or deactivate the impedance detection device according to a temperature deviation of the battery cells and detect an abnormal cell among the battery cells based on the impedance data, preferably when the impedance detection device is activated.

The controller may be configured to activate the impedance detection device if the temperature deviation is greater than or equal to a predetermined value. This allows minimizing the electric power consumption further, e.g., by adapting the predetermined value according to the technical or safety demands.

The controller may be configured to activate the impedance detection device if the temperature deviation is 1°C or more, e.g., 2°C or more, e.g., 3°C or more. This provides a tradeoff between the electric power consumption and monitoring demands.

The controller may be configured to deactivate the impedance detection device if an abnormal cell is not detected among the battery cells. This allows minimizing the electric power consumption further.

The battery diagnosis device may further include a discharging device that is configured to be connected between both ends of a battery module including the plurality of battery cells and forms a discharging path through which the AC current signal flows. The impedance detection device may be configured to control a current flow of the discharging path to generate the AC current signal. For example, the ends include a first end and a second end of a battery module. This provides a cost-efficient and energy efficient architecture.

The discharging device may include: a switch configured to be connected to a first end of the battery module; and a discharging load configured to be connected between the switch and a second end of the battery module. This provides a cost-efficient and energy efficient architecture.

The impedance detection device may include: an AC signal generator configured to generate an AC signal and outputs the AC signal to the discharging device; and an impedance detector configured to detect the AC current signal and the AC voltage signal, generate the impedance data based on the AC current signal and the AC voltage signal, and transfer the impedance data to the controller. Switching of the switch may be controlled by the AC signal, and the AC current signal may be generated according to the switching of the switch. This provides a cost-efficient and energy efficient architecture.

The AC signal generator may be configured to sequentially change a frequency of the AC signal output to the discharging device, and the AC current signal may have the same frequency as that of the AC signal. This allows a more complex analysis for obtaining the impedance data, e.g., by a spectroscopy.

The AC signal generator may be configured to output the AC signal to the discharging device if the impedance detection device is activated, the AC signal generator may be configured to output a blocking signal to the discharging device if the impedance detection device is deactivated, and the switch may be placed when an off state by the blocking signal is received by the impedance detection device. This allows minimizing the electric power consumption further.

The impedance detector may be configured to generate and transfer the impedance data when the impedance detection device is activated, and the impedance detector may be configured to stop generating and transferring the impedance data when the impedance detection device is deactivated. This allows minimizing the electric power consumption further.

A battery system according to embodiments of the present disclosure includes: a battery module that includes a plurality of battery cells; and the battery diagnosis device. This provides a cost-efficient and energy efficient architecture.

A battery diagnosis method according to embodiments of the present disclosure includes: calculating a temperature deviation of battery cells; activating an impedance detection device to detect impedance data of each of the battery cells using an electrochemical impedance spectroscopy when the temperature deviation is greater than or equal to a predetermined value; and detecting an abnormal cell among the battery cells based on the impedance data. This allows a more complex analysis for obtaining the impedance data.

The battery diagnosis method may further include deactivating the impedance detection device when an abnormal cell is not detected among the battery cells. This allows minimizing the electric power consumption further.

The battery diagnosis method may further include stopping charging and discharging of the battery cells when the abnormal cell is detected. This allows minimizing the electric power consumption further.

According to the present disclosure, power consumption due to electrochemical impedance spectroscopy (EIS) diagnosis of a battery system may be minimized.

However, effects that may be obtained through the present disclosure is not limited to the above-described effects, and other technical effects not mentioned may be clearly understood by those skilled in the art from a description of the present disclosure below.

### BRIEF DESCRIPTION OF THE DRAWINGS

The drawings illustrate embodiments of the present disclosure and serve to further describe technical ideas of the present disclosure together with a detailed description of the present disclosure below. The present disclosure is not limited to the embodiments depicted in the drawings.
FIG. 1 shows a battery system according to embodiments of the present disclosure.
FIG. 2 is a flowchart of a battery diagnosis method of the battery system according to embodiments of the present disclosure.

### DETAILED DESCRIPTION OF THE EMBODIMENTS

Below, embodiments of the present disclosure will be described in detail with reference to the attached drawings. Terms or words used in the present specification and claims should not be construed as limited to their usual or dictionary meanings and should be interpreted as meanings and in concepts conforming to the technical ideas of the present disclosure based on a principle that an inventor may properly define a concept of the term to describe his or her invention in the best way. The embodiments described in the present specification and a configuration shown in the drawings are only examples of the present disclosure and do not represent all of the technical ideas of the present disclosure, so that it should be appreciated that there may be various equivalents and variations that may replace the embodiments and the configurations described herein.

The terms "comprises", "includes", "comprising", or "including" when used in the present specification, specifies presence of a shape, a number, a step, an operation, a member, an element, and/or a group thereof, but do not preclude presence or addition of one or more other shapes, one or more other numbers, one or more other operations, one or more other members, one or more other elements, and/or a group thereof. Further, a use of "may" when the embodiments of the present disclosure described are described refers to "one or more embodiments of the present disclosure".

To help with understanding of the present disclosure, the drawings may not be shown at an actual scale, and dimensions of some components may be exaggerated in the drawings. In addition, the same reference number may be assigned to the same component in different embodiments.

When two objects are described as being identical, this means that the objects are "substantially identical". Therefore, the substantially identical objects may include objects having deviations considered low in the art, for example, deviations within 5%. Additionally, when it is described that certain parameters are uniform in a predetermined region, this may mean that the parameters are uniform in terms of an average.

Although terms "first", "second", and the like are used to describe various components, the components are not limited by the terms. The terms are only used to distinguish one component from another component, and unless otherwise stated, the first component may be the second component.

Throughout the specification, unless otherwise stated, each component may be singular or plural.

Disposing any component at an "upper portion (or lower portion)" of or "on (or below)" another component may mean not only that the component is disposed in contact with an upper surface (or lower surface) of the other component but also that another component may be interposed between the other component and the component disposed on (or below) the other component.

When it is described that a component is "connected", "coupled", or "accessed" to another component, the components may be directly connected or accessed to each other, but it should be understood that another component may be "interposed" between the components or the components may be "connected", "coupled", or "accessed" through another component. In addition, when one portion is referred to as being electrically coupled or connected to another portion, this includes not only a case where the one portion is directly coupled to the other portion but also a case where the one portion is coupled to the other portion via an intervening element.

Throughout the specification, when referring to "A and/or B", it means A, B, or A and B, unless specifically stated to the contrary. That is, the term "and/or" includes any and all combinations of a plurality of items listed. When referring to "C to D", unless otherwise specified, it means that it is greater than or equal to C and less than or equal to D.

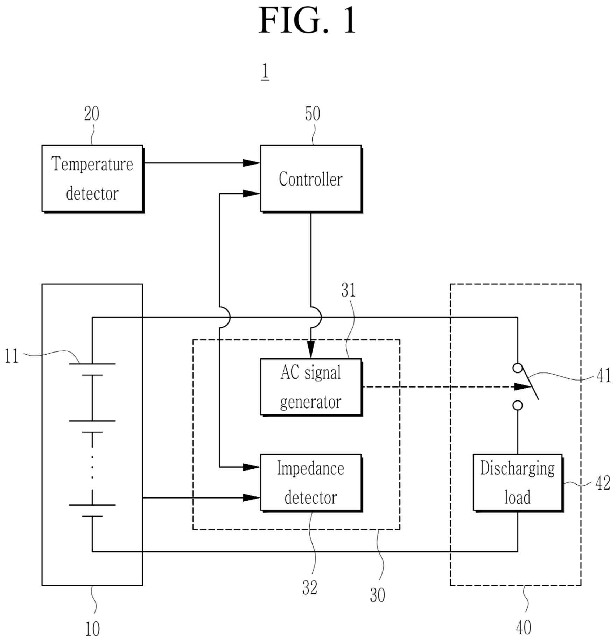

FIG. 1 schematically shows a battery system according to embodiments.

Referring to FIG. 1, a battery system 1 according to embodiments may include a battery module 10 and a battery diagnosis device. The battery module 10 may include a plurality of battery cells 11 that are connected in series and/or in parallel with each other.

The battery diagnosis device may monitor a temperature of each of the battery cells 11, and the battery diagnosis device may selectively perform an electrochemical impedance spectroscopy (EIS) diagnosis function according to (e.g., based on) a temperature monitoring result. The battery diagnosis device may include a temperature detector 20, an impedance detection device 30, a discharging device 40, and a controller 50.

The temperature detector 20 may detect a temperature of each of the battery cells 11 included in the battery module 10. The temperature detector 20 may include various temperature sensors capable of being used to measure the temperature of the battery cells 11 such as a thermocouple, a thermistor, a resistance temperature detector (RTD), a bi-metal, and a strain gauge.

The impedance detection device 30 may detect an impedance of each of the battery cells 11 based on an EIS diagnostic method. The impedance detection device 30 may include an AC signal generator 31 for causing an AC current signal to flow through the battery cells 11, and an impedance detector 32 for detecting the impedance of each of the battery cells 11 when the AC signal flows through the battery cells 11.

The AC signal generator 31 may generate an AC signal for EIS diagnosis if the EIS diagnosis function is activated. The AC signal generator 31 may generate the AC signal by changing a frequency of the AC signals and may sequentially output the generated AC signals of different frequencies. For example, the AC signal generator 31 may generate a plurality of AC signals having frequencies of 0.01 Hz or more and 4 kHz or less, and the AC generator 31 may sequentially output the generated plurality of AC signals.

The AC signal output by the AC signal generator 31 may be transferred to the discharging device 40 (described below). The AC signal transferred to the discharging device 40 may control the discharging device 40 to generate an AC current signal that flows through the battery cells 11.

The AC signal generator 31 may output a blocking signal if the EIS diagnosis function is deactivated. In such a case, the AC signal generator 31 may maintain output of the blocking signal while the EIS diagnosis function is maintained in an inactive state. The blocking signal output by the AC signal generator 31 may be transferred to the discharging device 40. The blocking signal transferred to the discharging device 40 may block a current signal from flowing to the battery cells 11 by the discharging device 40.

The impedance detector 32 may measure a voltage signal of each of the battery cells 11 when the EIS diagnosis function is activated so that the AC current signal flows through the battery cells 11. If the AC current signal flows through the battery cells 11, the voltage signal output from each of the battery cells 11 may be an AC voltage signal corresponding to the AC current signal. The impedance detector 32 may detect the impedance of each of the battery cells 11 by analyzing the measured AC current signal and the measured AC voltage signal. The impedance of each of the battery cells 11 may include, for example, an electrolyte resistance (Rs), a film resistance (Rf), a charge transfer resistance (Rct), a film capacitance (Cf), a charge double layer capacitance (Cdl), a constant phase element (CPE), a Warburg impedance (Zw), and the like of the battery cell 11. Determining the impedance of the battery cell 11 using the AC current signal and the AC voltage signal detected from the battery cell 11 may use techniques known in a field of an EIS diagnosis technology, so that a detailed description thereof is omitted.

The impedance detector 32 may repeatedly perform a process of measuring a current signal flowing through the battery module 10 and a voltage signal of each of the battery cells 11 whenever a frequency of the AC signal output from the AC signal generator 31 is changed. And the impedance detector 32 may perform a process of determining the impedance of each of the battery cells 11 based on the measured current signal and the measured voltage signal. Through repeated execution, the impedance detector 32 may determine an impedance for each frequency of each of the battery cells 11. When the impedance of each of the battery cells 11 for each frequency is determined, the impedance detector 32 may transfer impedance data including an impedance value for each frequency of each of the battery cells 11 to the controller 50. If the EIS diagnosis function is deactivated, the impedance detector 32 may stop an impedance detection operation.

The impedance detection device 30 may include at least one integrated circuit (IC). For example, the impedance detection device 30 may include one IC (e.g., an analog front end (AFE) IC) for performing functions of the AC signal generator 31 and the impedance detector 32. Additionally, the impedance detection device 30 may include a plurality of ICs for performing the functions of the AC signal generator 31 and the impedance detector 32. Each IC may be configured to perform one of the separate functions of the AC signal generator 31 and the impedance detector 32, or each IC may be configured to perform all the functions of the AC signal generator 31 and the impedance detector 32. In the latter case, the battery cells 11 may be classified into a plurality of battery cell groups, and ICs for each cell group may be configured to perform an impedance detection function.

The impedance detection device 30 may include an electronic circuit for performing the functions of the AC signal generator 31 and the impedance detector 32.

The discharging device 40 may be connected between ends (e.g., positive and negative electrodes) of the battery module 10 to form a discharging path between the ends of the battery module 10. The discharging device 40 may selectively generate a current signal that flows through the battery module 10 when the EIS diagnosis function is activated.

When the EIS diagnosis function is activated, the discharging device 40 may receive an AC signal from the AC signal generator 31. The discharging device 40 may generate an AC current signal flowing through the battery module 10 according to the received AC signal. The AC current signal flowing through the battery module 10 may have the same frequency as that of the AC signal output from the AC signal generator 31.

When the EIS diagnosis function is deactivated, the discharging device 40 may receive a blocking signal from the AC signal generator 31. If the blocking signal is received, the discharging device 40 may block a discharging path corresponding to the blocking signal so that the AC current signal is not generated.

In the example illustrated in FIG. 1, the discharging device 40 includes a switch 41 and a discharging load 42. The switch 41 and the discharging load 42 may be connected between ends of the battery module 10 to form a discharging path of the battery module 10.

The switch 41 may be connected between an end (e.g., the positive electrode) of the battery module 10 and the discharging load 42. If the switch 41 is in an off state (e.g., an open state or a non-conductive state), an electrical connection between the end of the battery module 10 and the discharging load 42 may be blocked at the switch 41. If the switch 41 is in an on state (e.g., a closed state or a conductive state), the electrical connection between the end of the battery module 10 and the discharging load 42 is not blocked at the switch 41.

An output signal (e.g., the AC signal or the blocking signal) output from the AC signal generator 31 may control the on state (e.g., the closed state or the conductive state) and the off state (e.g., the open state or the non-conductive state) of the switch 41. As the AC signal is received from the AC signal generator 31, the switch 41 may repeat switching (e.g., the on state to the off state and the off state to the on state) according to the received AC signal. Therefore, while the AC signal is received, an AC current signal may flow between both ends of the battery module 10.

If the blocking signal is received from the AC signal generator 31, the switch 41 may be turned off in response to the received blocking signal. The state may then be maintained.

The switch 41 may include various types of switching elements. For example, the switch 41 may include a field effect transistor (FET).

The discharging load 42 may be connected between the switch 41 and an end (e.g., the negative electrode) of the battery module 10. If the switch 41 is in the on state, the discharging load 42 may form a discharging path between both ends of the battery module 10 to generate a discharging current signal flowing through the battery module 10. The discharging load 42 may include a discharging resistor.

The controller 50 may receive from the temperature detector 20 a temperature value of each of the battery cells 11. The controller 50 may analyze temperature values received from the temperature detector 20 to determine whether the EIS diagnosis function should be activated. For example, the controller 50 may control driving of the impedance detection device 30 and driving of the discharging device 40 according to the temperature values received from the temperature detector 20. The controller 50 may calculate a temperature deviation in the battery cells 11 constituting the battery module 10, and the controller 50 may determine whether the EIS diagnosis function is activated according to the calculated temperature deviation. If the temperature deviation of the battery cells 11 is greater than or equal to a predetermined value (e.g., 1°C or more, e.g., 2°C or more, e.g., 3°C or more), the controller 50 may activate the EIS diagnosis function. If the temperature deviation of the battery cells 11 is less than the predetermined value, the controller 50 may deactivate the EIS diagnosis function. As used herein, the term "temperature deviation" may refer to a temperature difference between the battery cells 11. Therefore, a condition that "the temperature deviation is equal to or greater than a predetermined value (e.g., 1°C or more, e.g., 2°C or more, e.g., 3°C or more)" may be satisfied when the difference between the maximum and minimum temperatures among the battery cells 11 is equal to or greater than the predetermined value.

The controller 50 may activate the EIS diagnosis function by activating the impedance detection device 30. If it is determined that the EIS diagnosis function should be activated, the controller 50 may control the AC signal generator 31 to output an AC signal for EIS diagnosis sending the control signal to the AC signal generator 31. And the controller 50 may control the impedance detector 32 to perform an impedance detection operation by sending the control signal to the impedance detector 32. If the AC signal generator 31 outputs the AC signal, the discharging function of the discharging device 40 is activated so that an AC current signal flows through the battery module 10.

If it is determined that the EIS diagnosis function should be deactivated, the controller 50 may send a control signal to the AC signal generator 31 to stop output of the AC signal for EIS diagnosis. Thus, the AC signal generator 31 will stop output of the AC signal and output the blocking signal. The controller 50 may also control the impedance detector 32 to stop the impedance detection operation by sending the control signal to the impedance detector 32. When the AC signal generator 31 outputs the blocking signal, the discharging function of the discharging device 40 is deactivated so that a discharging path by the discharging device 40 is blocked.

When the impedance detection device 30 is activated so that impedance data of each of the battery cells 11 is obtained, the controller 50 may analyze the impedance data to diagnose a state of each of the battery cells 11. For example, the controller 50 may diagnose an internal state of each of the battery cells 11 such conductivity (e.g., ionic conductivity or electrical conductivity based on the impedance data of each of the cells 11. The controller may also diagnose an internal resistance, an electrode reaction speed, a deterioration state, a state of charge (SOC), an internal short circuit, lithium plating, or the like based on the impedance data of each of the battery cells 11. Diagnosing the internal state of the battery cell 11 based on the impedance data of the battery cell 11 is known in a field of an EIS diagnosis technology. As such, a detailed description thereof is omitted.

The controller 50 may detect an abnormal cell among the battery cells 11 according to a diagnosis result of the internal state of each of the battery cells 11. For example, the controller 50 may detect that one of the battery cells 11 has an internal short circuit. In some embodiments, the controller 50 may detect that one of the battery cells 11 is abnormally deteriorated or has a high degree of deterioration.

When an abnormal cell is detected, the controller 50 may perform a protection function. For example, the controller 50 may stop charging and discharging of the battery system 1 by blocking an electrical connection between the battery system 1 and an external device (e.g., a load, a charger, or an electric power system). The controller 50 may also send a notification signal indicating detection of an abnormal cell to an upper controller (not shown).

The controller 50 may include at least one processor for performing a function of the controller 50 described above. The processor may refer to a data processing device such as a microprocessor, a central processing unit (CPU), a processor core, a multiprocessor, an application-specific integrated circuit (ASIC), or a field programmable gate array (FPGA)) having a physically structured circuit to perform a function expressed by a code or a command included within a program. But the processing device according to the present disclosure is not limited to these examples.

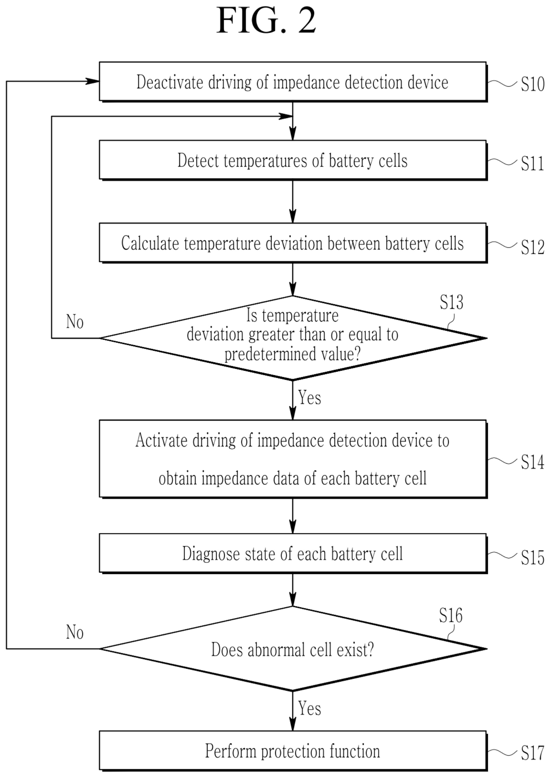

FIG. 2 is a flowchart of a battery diagnosis method of the battery system 1 according to embodiments of the present disclosure. The method of FIG. 2 may be performed by the controller 50 described above with reference to FIG. 1.

Referring to FIG. 2, during initial driving of the battery system 1, the controller 50 may deactivate the impedance detection device 30 in step S10. That is, the controller 50 may deactivate the impedance detection device 30 by controlling the AC signal generator 31 to stop output of an AC signal for EIS diagnosis, and the controller 50 may control the impedance detector 32 to stop an impedance detection operation. If the AC signal generator 31 outputs a blocking signal, a discharging function of the discharging device 40 may be stopped by a discharging path by the discharging device 40 being blocked.

Thereafter, the controller 50 may detect temperatures of the battery cells 11 included in the battery module 10 using the temperature detector 20 in step S11. In step S12, the controller 50 may calculate a temperature deviation between the battery cells 11 based on a temperature of the cell detected through a step S11. The controller 50 may determine whether the temperature deviation calculated in the step S12 is greater than or equal to a predetermined value in step S13. For example, the controller 50 may determine whether the temperature deviation between the battery cells 11 is 1°C or more, e.g., 2°C or more, e.g., 3°C or more.

If the temperature deviation of the battery cells 11 is greater than or equal to the predetermined value, in step S14 the controller 50 may activate the impedance detection device 30 to obtain impedance data of each of the battery cells 11. In a step S14, the controller 50 may activate the driving of the impedance detection device 30 by causing the AC signal generator 31 to output the AC signal for EIS diagnosis. The controller 50 may control the impedance detector 32 to perform an impedance detection operation. When the AC signal generator 31 outputs the AC signal, a discharging function of the discharging device 40 may be activated so that an AC current signal flows through the battery module 10.

The controller 50 may analyze the impedance data obtained in step S14 to diagnose a state of each of the battery cells 11 (S15). For example, the controller 50 may diagnose conductivity (e.g., ionic conductivity or electrical conductivity), an internal resistance, an electrode reaction speed, a deterioration state, a state of charge (SOC), an internal short circuit, lithium plating, or the like of each of the battery cells 11 based on the impedance data of each of the battery cells 11. In step S16, the controller 50 may determine whether there is an abnormal cell among the battery cells 11 based on a diagnosis result in a step S15.

When an abnormal cell is not detected, in step S10 the controller 50 may deactivate the driving of the impedance detection device 30 again. When at least one abnormal cell is detected, in step S17 the controller 50 may perform a protection function of the battery system 1. For example, the controller 50 may stop charging and discharging of the battery system 1. The controller 50 may output a notification signal that indicates the detection of an abnormal cell to an upper controller (not shown).

FIG. 2 illustrates an example in which the controller 50 controls the impedance detection device 30 to be in an inactive state during the initial driving of the battery system 1. But, in other embodiments, the driving of the impedance detection device 30 may be deactivated without control of the controller 50 during the initial driving of the battery system 1. In such embodiments, the impedance detection device 30 may be configured to automatically be in the inactive state during the initial driving and then to be switched to an active state by a control signal received from the controller 50.

According to the above-described embodiments, the battery diagnosis device may quickly detect when there is a high possibility of existence of the abnormal cell based on cell temperatures of the battery cells 11. When it is determined that there is the high possibility of the existence of the abnormal cell (e.g., if the temperature is more than 1°C, e.g., than 2°C, e.g., than 3°C), the battery diagnosis device may activate the impedance detection device 30 to precisely diagnose states of the battery cells 11. Thus, detection speed and detection accuracy of abnormal cells are increased.

According to the above-described embodiments, the battery diagnosis device may generate the AC current signal used for the EIS diagnosis by discharging the battery module 10 through the discharging device 40 instead of applying the AC current signal generated using a separate power source to the battery module 10. If the impedance detection device 30 is continuously operated, not only the impedance detection device's 30 own electric power consumption but also power consumption due to discharging of the discharging device 40 may continuously occur such that a significant amount of power loss of the battery system 1 may occur. However, as in the above-described embodiments where the impedance detection device 30 is deactivated when the battery module 10 is in a normal state and the impedance detection device 30 is activated only in a situation where there is a high possibility of existence of the abnormal cell, power loss due to the EIS diagnosis may be significantly reduced.

The above-described embodiments may be implemented through the device and/or the method described above, and may also be implemented through a program that realizes a function corresponding to a configuration of each of the embodiments, or a computer-readable recording medium having the program recorded thereon. Such an implementation may be easily implemented by a person skilled in the art to which the present disclosure belongs from the description of the above-described embodiments. The computer-readable recording medium may include all types of recording devices that store data that may be read by a computer system. Examples of the computer-readable recording medium include a ROM, a RAM, a CD-ROM, a DVD-ROM, a DVD-RAM, a magnetic tape, a floppy disk, a hard disk, an optical data storage device, or the like.

An exemplary implementation of the temperature detector is configured to detect, for each of the battery cells, a temperature of the battery cells and/or an average temperature of the battery cells.

An exemplary implementation of the impedance detection device is configured to determine the impedance data of each of the battery cells based on one or more AC signals, for which examples include: the AC current signal and/or the AC voltage signal.

An exemplary implementation of the temperature deviation includes one or more of: a temperature variance (or standard deviation) among the battery cells and/or a deviation of the temperature of one or more of the of the battery cells from a (e.g., stored) reference temperature. Examples of the reference temperature include: a (e.g., stored) predetermined temperature, a (e.g., sensed) temperature of one of the battery cells (e.g., the lowest temperature), an average temperature of the battery cells, the lowest temperature among the temperatures of the battery cells.

An exemplary implementation of the controller is configured to activate the impedance detection device in response to the temperature deviation of the battery cells fulfilling a first condition. Alternatively or additionally the controller is configured to deactivate the impedance detection device in response to the temperature deviation of the battery cells fulfilling a second condition. As example, the first condition may be satisfied when the temperature deviation is greater than or equal to the predetermined value, e.g., exceeds a (e.g., stored) temperature threshold, and/or may be satisfied at a higher temperature as the second criterion. As example, the second condition may be satisfied when an abnormal cell is not detected among the battery cells and/or at a lower temperature than the first criterion.

According to various aspects, a (e.g., battery diagnosis) method comprises: determining a temperature deviation of battery cells; activating an impedance detection device to detect impedance data of each of the battery cells based on an AC current signal flowing through battery cells and a corresponding AC voltage signal (e.g., generated by the impedance detection device), when the temperature deviation is greater than or equal to a predetermined value; and determining an abnormal cell among the battery cells based on the impedance data.

According to various aspects, a (e.g., battery diagnosis) method comprises: generating, e.g., by an impedance detection device, an AC current signal flowing through battery cells (e.g., when the temperature deviation of the battery cells is greater than or equal to a predetermined value); detect an AC voltage signal corresponding to the AC current signal for each of the battery cells, and determine impedance data of each of the battery cells based on the AC current signal and the AC voltage signal. **The** method may optionally further include: activating or deactivating, e.g., by a controller, the impedance detection device based on a temperature deviation of the battery cells and/or detecting an abnormal cell among the battery cells based on the impedance data.

According to various aspects a temperature deviation of battery cells is used to determine (e.g., trigger) an activation or deactivation of an impedance detection device configured to generate an AC current signal flowing through the battery cells, determine an AC voltage signal corresponding to the AC current signal for each of the battery cells, and determine impedance data of each of the battery cells based on the AC current signal and the AC voltage signal, wherein, preferably, an abnormal cell among the battery cells is detected based on the impedance data when the impedance detection device is activated.

An exemplary implementation of the AC voltage signal is a response of the battery cell to the AC current signal flowing through the battery cell. An exemplary implementation of the electrochemical impedance spectroscopy is based on the AC current signal and the AC voltage signal, e.g., by sequentially changing the frequencies of the generated AC current signal.

Although the present disclosure has been described above by embodiments and the drawings, the present disclosure is not limited thereto, and various modifications and variations may be made within an equivalent scope of the technical idea of the present disclosure by those of ordinary skill in the art.

### <Description of symbols>

1: battery system
10: battery module
11: battery cell
20: temperature detector
30: impedance detection device
31: AC signal generator
32: impedance detector
40: discharging device
41: switch
42: discharging load
50: controller

## Claims

1. A battery diagnosis device comprising:
a temperature detector (20) configured to detect temperatures of battery cells (11);
an impedance detection device (30) configured to generate an AC current signal flowing through the battery cells (11), detect an AC voltage signal corresponding to the AC current signal for each of the battery cells (11), and detect impedance data of each of the battery cells (11) based on the AC current signal and the AC voltage signal; and
a controller (50) configured to activate or deactivate the impedance detection device (30) according to a temperature deviation of the battery cells (11) and detect an abnormal cell (11) among the battery cells (11) based on the impedance data when the impedance detection device (30) is activated.

2. The battery diagnosis device as claimed in claim 1, wherein the controller (50) is configured to activate the impedance detection device (30) if the temperature deviation is greater than or equal to a predetermined value.

3. The battery diagnosis device as claimed in claim 2, wherein the controller (50) is configured to activate the impedance detection device (30) if the temperature deviation is 3 °C or more.

4. The battery diagnosis device as claimed in claim 2 or 3, wherein the controller (50) is configured to deactivate the impedance detection device (30) if an abnormal cell (11) is not detected among the battery cells (11).

5. The battery diagnosis device as claimed in one of claims 1 to 4, further comprising a discharging device (40) configured to be connected between ends of a battery module (10) including the battery cells (11) and form a discharging path through which the AC current signal flows,
wherein the impedance detection device (30) is configured to control a current flow of the discharging path to generate the AC current signal.

6. The battery diagnosis device as claimed in claim 5, wherein the discharging device (40) comprises:
a switch (41) configured to be connected to a first end of the battery module (10); and
a discharging load (42) configured to be connected between the switch (41) and a second end of the battery module (10).

7. The battery diagnosis device as claimed in claim 6, wherein the impedance detection device (30) comprises:
an AC signal generator (31) configured to generate an AC signal and output the AC signal to the discharging device (40); and
an impedance detector (32) configured to detect the AC current signal and the AC voltage signal, generate the impedance data based on the AC current signal and the AC voltage signal, and transfer the impedance data to the controller (50),
wherein switching of the switch (41) is controlled by the AC signal, and the AC current signal is generated according to the switching of the switch (41).

8. The battery diagnosis device as claimed in claim 7, wherein the AC signal generator (31) is configured to sequentially change a frequency of the AC signal output to the discharging device (40), and the AC current signal has the same frequency as that of the AC signal.

9. The battery diagnosis device as claimed in claim 7 or 8, wherein the AC signal generator (31) is configured to output the AC signal to the discharging device (40) if the impedance detection device (30) is activated, the AC signal generator (31) is configured to output a blocking signal to the discharging device (40) if the impedance detection device (30) is deactivated, and the switch (41) is place in an off state when the blocking signal is received by the impedance detection device (30).

10. The battery diagnosis device as claimed in one of claims 7 to 9, wherein the impedance detector (32) is configured to generate and transfer the impedance data when the impedance detection device (30) is activated, and the impedance detector (32) is configured to stop generating and transferring the impedance data when the impedance detection device (30) is deactivated.

11. A battery system (1) comprising:
a battery module (10) that includes a of battery cells (11); and
the battery diagnosis device according to one of claims 1 to 10.

12. A battery diagnosis method comprising:
calculating a temperature deviation of battery cells (11);
activating an impedance detection device (30) to detect impedance data of each of the battery cells (11) using an electrochemical impedance spectroscopy when the temperature deviation is greater than or equal to a predetermined value; and
detecting an abnormal cell (11) among the battery cells (11) based on the impedance data.

13. The battery diagnosis method as claimed in claim 12, further comprising deactivating the impedance detection device (30) when an abnormal cell (11) is not detected among the battery cells (11).

14. The battery diagnosis method as claimed in claim 12 or 13, further comprising stopping charging and discharging of the battery cells (11) when the abnormal cell (11) is detected.

15. Using a temperature deviation of battery cells to determine an activation or deactivation of an impedance detection device (30) configured to: generate an AC current signal flowing through the battery cells (11), determine an AC voltage signal corresponding to the AC current signal for each of the battery cells (11), and determine impedance data of each of the battery cells (11) based on the AC current signal and the AC voltage signal, wherein an abnormal cell among the battery cells is detected based on the impedance data when the impedance detection device is activated.
